# EUROPÄISCHE PATENTSCHRIFT

(11) **EP 1 400 490 B1**
(45) Veröffentlichungstag und Bekanntmachung des Hinweises auf die Patenterteilung: **05.04.2006**
(21) Anmeldenummer: 03016937.9
(22) Anmeldetag: 25.07.2003
(51) Int. Cl.: C01B 33/029, B01J 19/00, B01J 19/02, C23C 16/24

(54) **Abscheidung eines Feststoffs durch thermische Zersetzung einer gasförmigen Substanz in einem Becherreaktor**
Deposition of a solid by thermal decomposition of a gaseous substance in a bowl reactor
Dépôt d'un solide par la décomposition thermique d'un substance gazeuse dans un réacteur en forme de cuvette

(30) Priorität: 17.09.2002 DE 10243022
(43) Veröffentlichungstag der Anmeldung: 24.03.2004
(73) Patentinhaber: Degussa AG, 40474 Düsseldorf (DE)
(72) Erfinder: Sonnenschein, Raymund, Dr., 60594 Frankfurt (DE)

(56) Entgegenhaltungen:
- WO-A-84/00156
- GB-A- 745 698
- GB-A- 878 763
- US-A- 2 989 378
- US-A- 4 642 227
- US-B1- 6 284 312

## Beschreibung

Die vorliegende Erfindung betrifft ein neues Verfahren und eine neue Vorrichtung zur Abscheidung eines Feststoffs (B) durch thermische Zersetzung einer gasförmigen Substanz (A) in einem Reaktor, wobei die eingesetzte Substanz (A) eine höhere Dichte besitzt als die bei der Zersetzung entstehenden gasförmigen Produkte (C), insbesondere zur Herstellung vorwiegend block- bzw. zylinderförmiger Körper aus hochreinem polykristallinen Silicium aus Monosilan.

Es ist lange bekannt, unter Einfluss höherer Temperatur Silane in Silicium und Nebenprodukte zu zersetzen und polykristallines Silicium abzuscheiden. Diese Methode ist auch unter dem Begriff CVD-Verfahren (Chemical Vapor Deposition) bekannt. Bisherige, industriell angewandte Verfahren zur Herstellung von reinem, polykristallinem Silicium verwenden Trichlorsilan (HSiCl₃) oder Monosilan (SiH₄) als Rohstoff.

Bei der Verwendung von Trichlorsilan entstehen als Nebenprodukte Siliciumtetrachlorid, Chlor, Wasserstoff und andere, in der Regel recyclierbare Stoffe.

Demgegenüber fällt bei der Verwendung von Monosilan lediglich Wasserstoff an. So kann man Monosilan an einem mittels elektrischem Strom erhitzten Siliciumstab (Siemens-Verfahren) oder in einer beheizten Wirbelschicht zersetzen.

In neueren Verfahren geht man zu einer Abscheidung in einem horizontal oder vertikal orientierten Rohr über (US 6 284 312, US 6 365 225, WO 01/61070).

Nach CVD-Verfahren gewonnenes, hochreines Silicium wird in der Regel in Schmelzverfahren zur Herstellung von mono- oder polykristallinem Silicium eingesetzt. Insbesondere beim Schmelzverfahren ist man bestrebt, das hochreine Silicium möglichst in stückiger Form, als Granulat, als Block oder als Stab, einzusetzen.

Leider fällt bei den bekannten CVD-Verfahren ein hoher Anteil an staubförmigem Silicium an, was mit Hinblick auf ein stückförmiges Zielprodukt zu einem deutlichen Materialverlust beiträgt.

Darüber hinaus kommt es bei den bekannten Verfahren zu unerwünschten, mehr oder weniger starken Anbackungen von Silicium an den Wänden der Reaktionsbehälter.

Ferner kann meist nur stark verdünntes Substratgas eingesetzt werden.

Weiterhin ist ein hoher Energieaufwand durch hohe Mengenströme aufgrund hoher Verdünnung bei der Verwendung von Monosilan oder aufgrund zahlreicher Nebenprodukte bei Einsatz von Trichlorsilan von Nachteil.

Auch befinden sich bei den bekannten Verfahren, in denen Durchflussreaktoren eingesetzt werden, neben Staub noch deutliche Mengen Edukt im Abgas, was eine meist aufwendige Abgasreinigung bzw. ein aufwendiges Recycling erfordert.

Der vorliegenden Erfindung lag die Aufgabe zugrunde, ein weiteres Verfahren bereitzustellen, um oben genannte Nachteile nach Möglichkeit zu mindern.

Die gestellte Aufgabe wird erfindungsgemäß entsprechend den Angaben der Patentansprüche gelöst.

Überraschenderweise wurde gefunden, dass man in einfacher und besonders wirtschaftlicher Weise einen Feststoff (B) durch gezielte thermische Zersetzung einer gasförmigen Substanz (A) in stückiger Form und mit einem vergleichsweise geringen Anfall an stäubförmigem Silicium herstellen kann, wenn man die Zersetzung und Abscheidung der eingesetzten Substanz (A), die gegebenenfalls in einem Gasgemisch eingesetzt wird und eine höhere Dichte besitzt als die bei der Zersetzung entstehenden gasförmigen Produkte (C), in einer Vorrichtung durchführt, die gekennzeichnet ist durch einen Becher (1), dessen Boden (1.1) in Richtung der Erdanziehung (g) und dessen Öffnungsbereich (1.2) entgegen der Erdanziehung (g) orientiert ist, der Becher (1) durch eine Heiz-, Temperaturmess- und Regeleinheit (3.3) direkt oder indirekt beheizbar ist, eine Substanzaufgabeeinheit (2) mit Substanzzuleitung (3.1) und Dosierungseinheit (3.2), wobei die Substanzaufgabeeinheit (2) mit dem Substanzauslass (2.1) in Richtung der Erdanziehung (g) orientiert ist und in das Freivolumen des Bechers (1) zwischen Boden (1.1) und Öffnungsbereich (1.2) hineinragt, eine Reaktorhülle (3), die in geeigneter Weise zu öffnen ist und im Wesentlichen die Einheiten (1) und (2) gegenüber einem Gasaustausch mit der Umgebung abschließt, und einen Auslass (3.6) für vorwiegend gasförmige Produkte (C), dabei kann insbesondere, aber nicht ausschließlich, Monosilan als Substanz (A) thermisch zersetzt und polykristallines Silicium als Feststoff (B) im Becher (1) abgeschieden werden.

Die vorliegende Erfindung ist besonders wirtschaftlich, da der apparative Aufwand vergleichsweise gering ist, bei Einsatz von Monosilan als Substanz (A) nur Wasserstoff mit gegebenenfalls geringen Teilen Monosilan als Abgas anfällt und dabei ein vergleichsweise geringer Anteil an Siliciumstaub entsteht. Aufgrund der erfindungsgemäßen Verfahrensführung und Vorrichtung treten Anbackungen von Feststoff (B) an der Reaktorwand (3) in der Regel nicht auf. Ferner wird beim vorliegenden Verfahren als Abgas praktisch ausschließlich Edukt freier Wasserstoff erhalten. Die erzielte Abscheiderate an Feststoff (B) liegt in der Regel bei > 97 %. Darüber hinaus ist der Staubanteil im Abgas (C) nach Auslass (3.6) in der Regel nur gering. Auch ist das vorliegende Verfahren energisch besonders günstig, da man u. a. vergleichsweise geringe Stoffströme fahren kann.

So erhält man nach dem vorliegenden Verfahren in einer erfindungsgemäßen Vorrichtung vorteilhaft blockförmiges hochreines Silicium, das beispielsweise in Schmelzverfahren zur Gewinnung von mono- oder polykristallinem Silicium eingesetzt werden kann.

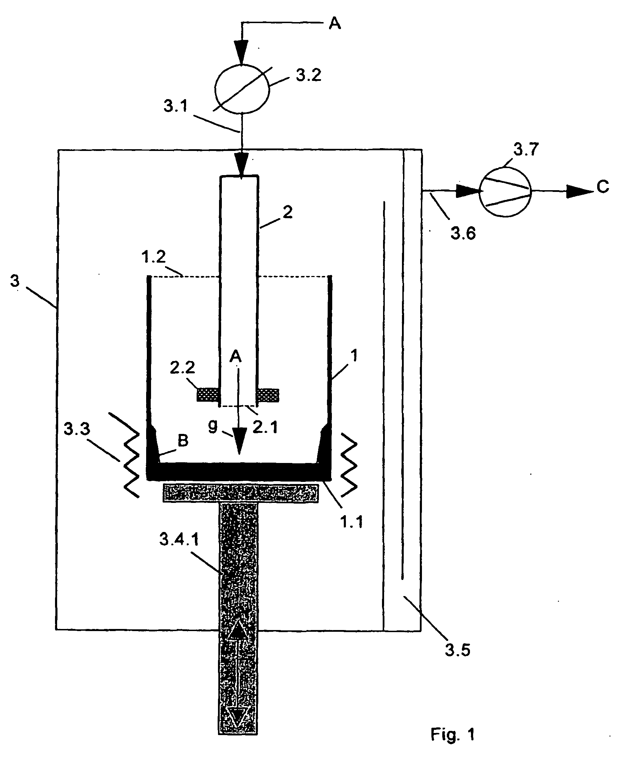

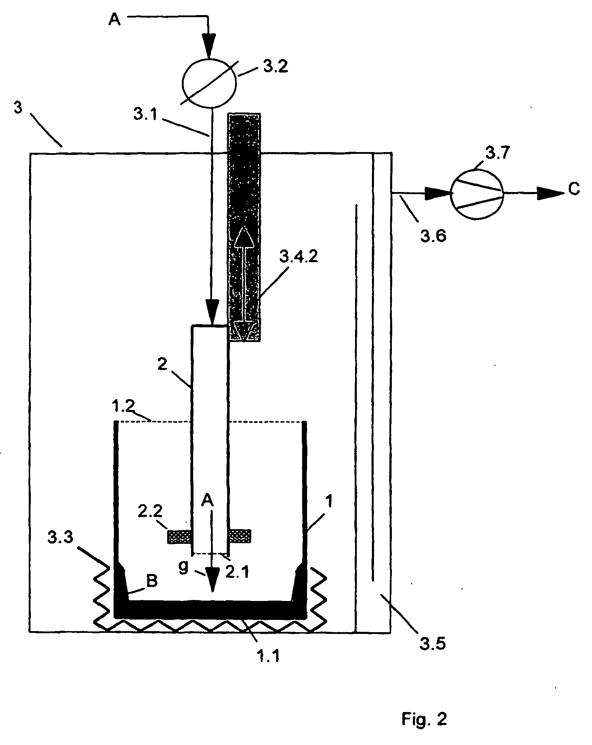

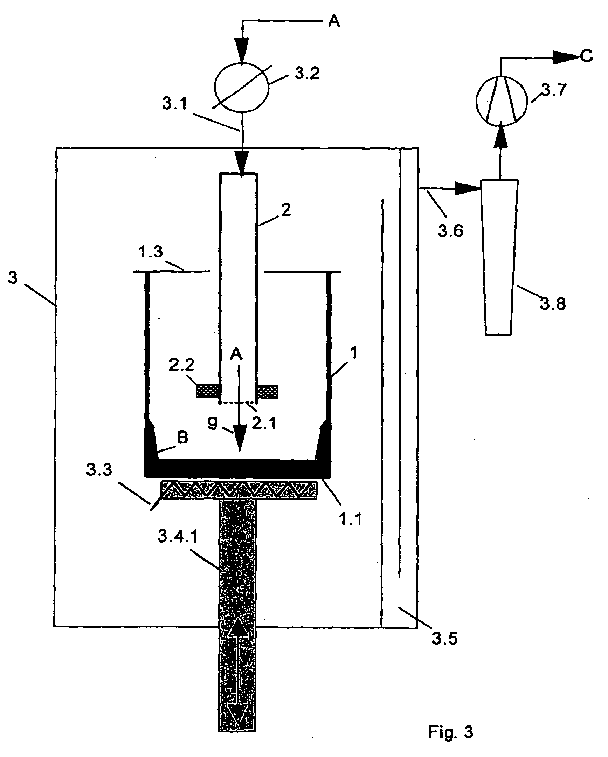

In den Abbildungen 1 bis 3 sind Skizzen bevorzugter Ausführungsformen erfindungsgemäßer Vorrichtungen, nachfolgend auch Becherreaktoren genannt, dargestellt, vgl. Fig. 1 bis 3.

Gegenstand der vorliegenden Erfindung ist somit eine Vorrichtung zur Abscheidung eines Feststoffs (B) durch thermische Zersetzung einer gasförmigen Substanz (A), wobei die eingesetzte Substanz (A) eine höhere Dichte besitzt als die bei der Zersetzung entstehenden gasförmigen Produkte (C),
gekennzeichnet durch
einen Becher (1), dessen Boden (1.1) in Richtung der Erdanziehung (g) und dessen Öffnungsbereich (1.2) entgegen der Erdanziehung (g) orientiert ist, der Becher (1) durch eine Heiz-, Temperaturmess- und Regeleinheit (3.3) direkt oder indirekt beheizbar ist,
eine Substanzaufgabeeinheit (2) mit Substanzzuleitung (3.1) und Dosierungseinheit (3.2), wobei die Substanzaufgabeeinheit (2) mit dem Substanzauslass (2.1) in Richtung der Erdanziehung (g) orientiert ist und in das Freivolumen des Bechers (1) zwischen Boden (1.1) und Öffnungsbereich (1.2) hineinragt,
eine Reaktorhülle (3) und einen Auslass (3.6) für gasförmige Produkte (C).

Bevorzugt können der Becher (1) und/oder die Substanzaufgabeeinheit (2) über mindestens eine Hebevorrichtung (3.4.1 bzw. 3.4.2) in Richtung der Erdanziehung abgesenkt bzw. angehoben werden. Geeigneterweise kann man die Hebevorrichtung 3.4.1 beheizbar ausführen, sodass z. B. die Standplatte des Bechers (1) eine Heizeinheit (3.3) enthält.

Ferner kann man im erfindungsgemäßen Becherreaktor dem Auslass (3.6) eine Verwirbelungssperre (3.5) zur Gasberuhigung und Partikelabscheidung vorschalten.

Zur Einstellung und Regelung der Durchsatzmenge an (A) kann man bei der vorliegenden Vorrichtung dem Auslass (3.6) eine Gasfördereinheit (3.7) nachschalten, vgl. Abb. 1 bis 3.

Weiterhin kann man bei der erfindungsgemäßen Vorrichtung der Gasfördereinheit (3.7) eine Staubabscheidung (3.8), beispielsweise einen Staubfilter, vor- und/oder nachschalten.

Die Substanzaufgabeeinheit (2) des vorliegenden Becherreaktors ist bevorzugt im Bereich des Substanzauslasses (2.1) mit einem Temperaturdetektor (2.2) ausgestattet.

Die Substanzaufgabeeinheit (2) kann vorzugsweise aus dem Feststoff (B), Quarzglas oder einem metallischen Werkstoff, wie Edelstahl, Titan oder eine Nickelbasislegierung, bestehen. Als Edelstahl kann man ferner eine hochtemperaturbeständige Nickellegierung, beispielsweise Inconell®, oder auch Ti, Nb, Ta verwenden. Die Lanze der Einheit (2) kann ferner kühlbar ausgeführt sein. Die Spitze der Lanze besitzt bevorzugt die Form eines umgedrehten Trichters, so dass eine möglichst langsame Aufgabe des Gases (A) in den Becher (1) gewährleistet werden kann und um nach Möglichkeit eine Verwirbelung der Gasschichtung zu vermeiden.

Der Becher (1) des erfindungsgemäßen Reaktors besteht bevorzugt aus dem Feststoff (B) und weist geeigneterweise eine Seitenhöhe von 10 bis 200 cm sowie eine Bodenfläche, d. h. Standfläche, von vorzugsweise 10 bis 10 000 cm² auf. Die Einheit (1) und die Lanze der Einheit (2) bestehen dabei geeigneterweise aus einem hochreinen Silicium.

So kann der Becher (1) der erfindungsgemäßen Vorrichtung geeigneterweise aus einer Scheibe mit einer Dicke bzw. Stärke von 0,01 bis 1 cm, vorzugsweise 0,3 bis 2 mm, aus hochreinem Silicium als Boden (1.1) und einem Rohr aus Silicium als Wand mit einer Wandstärke von 0,01 bis 1 cm, vorzugsweise 0,3 bis 2 mm, und vorzugsweise einem Durchmesser von 10 bis 50 cm bestehen, wobei das Rohr mit einer der beiden gegenüberliegenden Öffnungsflächen des Rohres im Wesentlichen senkrecht auf der ebenen Fläche der Siliciumscheibe steht und der Außendurchmesser des Rohres kleiner gleich dem Durchmesser der Siliciumscheibe ist. Bevorzugt verwendet man hier als Siliciumscheibe eine Waferscheibe. Die Achse eines solchen Rohres ist im Wesentlichen senkrecht zu mindestens einer der beiden Öffnungsflächen des Rohres orientiert. Geeigneterweise ist mindestens eine Öffnungsfläche plan, senkrecht zur Rohrachse orientiert und dient als Kontaktfläche zur ebenen Fläche der Waferscheibe. Die Ränder der Öffnungsfläche des Rohres können aber auch zackenförmig und unregelmäßig ausgeführt sein.

Bei der erfindungsgemäßen Vorrichtung kann der Becher (1) in Höhe des Öffnungsbereichs (1.2) zusätzlich mit einer Platte (1.3) bedeckt sein, die im Zentrum einen Durchlass für die Einheit (2) aufweist, wodurch die Gasdurchlässigkeit in der Regel gewährleistet bleibt. Eine solche Platte mit Loch als Durchlass für die Einheit (2) kann beispielsweise aus dem Feststoff (B) bestehen.

Auch stattet man die erfindungsgemäße Vorrichtung bevorzugt mit mindestens einer gasdicht schließenden Klappe oder einem gasdicht schließenden Deckel als Bestandteil der Reaktorhülle (3) aus.

Die Reaktorhülle (3) kann ferner mit einer Kühlung und gegebenenfalls einer Heizung ausgestattet werden. Geeigneterweise legt man die Reaktorhülle (3) für eine Temperatur von -100 bis +400 °C, vorzugsweise 10 bis 100 °C, aus. Auch sollte die Reaktorhülle (3) druckbeständig ausgeführt sein, wobei ein Betriebsdruck im Becherreaktor von 0,1 mbar absolut bis 50 bar absolut, insbesondere 0,1 bis 5 bar absolut, bevorzugt wird. Darüber hinaus ist eine gasdichte Ausführung zu bevorzugen, insbesondere gegenüber Sauerstoff aus der Luft.

Ferner ist Gegenstand der vorliegenden Erfindung ein Verfahren zur Abscheidung eines Feststoffs (B) durch die thermische Zersetzung einer gasförmigen Substanz (A), wobei die eingesetzte Substanz (A) oder ein die Substanz (A) enthaltendes Gasgemisch eine höhere Dichte besitzt als die bei der Zersetzung entstehenden gasförmigen Produkte (C), in einer erfindungsgemäßen Vorrichtung, indem man
- den Boden und/oder die Seitenwandung des Bechers (1) erwärmt,
- die gasförmige Substanz (A) über die Substanzaufgabeeinheit (2) von oben in das Innere von Becher (1) einbringt, geeigneterweise unter Ausnutzung der Schwerkraft,
- den durch die thermische Zersetzung von (A) entstehenden Feststoff (B) im Wesentlichen an der Innenseite des Bechers (1) abscheidet und
- die Produkte (C) über die Gasphase aus dem System entfernt.

Bevorzugt wird bei der Durchführung des erfindungsgemäßen Verfahrens die besagte Vorrichtung vor der Aufgabe der gasförmigen Substanz (A) evakuiert und/oder mit einem Gas oder Gasgemisch gezielt gefüllt, das eine geringere Dichte als die gasförmige Substanz (A) besitzt. Insbesondere setzt man Wasser und Sauerstoff freie Gase ein. Als Gase werden hierbei vorzugsweise Wasserstoff, Stickstoff, Ammoniak, Abgas (C) als Recycling, Helium, Argon oder eine Mischung zuvor genannter Gase eingesetzt.

Als Substanz (A) setzt man beim vorliegenden Verfahren bevorzugt reines Monosilan (SiH₄) ein. Vorzugsweise verwendet man ein Monosilan mit einer Reinheit von > 99,99 %.

Man kann aber auch andere SiH-Verbindungen, beispielsweise Disilane oder entsprechende Mischungen besagter SiH-Verbindungen einsetzen. Ferner kann man Chlorsilane oder Gemische aus Chlorsilanen und Silanen, d. h. SiH-Verbindungen, einsetzen. Gegebenenfalls kann man dem Gas (A) auch Metallwasserstoffverbindungen, wie BH₃, GaH₃, GeH₄, PH₃, AsH₃ - um nur einige Beispiele zu nennen, im Bereich von ppm-Mengen zusetzen, um eine gezielte Dotierung des Produkts zu bewirken. Vorzugsweise setzt man ein Gasgemisch ein, das 0,1 bis 100 Vol.-% Substanz (A), besonders bevorzugt 10 bis 100 Vol.%, enthält.

Insbesondere setzt man beim erfindungsgemäßen Verfahren als Substanz (A) reines Silan (SiH₄) oder ein Gemisch aus demselben mit Wasserstoff, Stickstoff, Ammoniakgas, Argon und/oder Helium ein.

In der erfindungsgemäßen Vorrichtung bzw. nach dem vorliegenden Verfahren kann man aber auch andere Reaktionen als die Zersetzung von Silanen zur Abscheidung von Silicium durchführen. So kann man beispielsweise ein Gemisch aus SiH₄ und NH₃ als Substanz (A) in einem Becher (1), der zum Beispiel aus Quarz besteht, zu Siliciumnitrid abscheiden.

Bei der Durchführung des erfindungsgemäßen Verfahrens stellt man bei der Beheizung des Bechers (1) geeigneterweise eine Temperatur ein, die höher als die Zersetzungstemperatur von der eingesetzten Substanz (A) liegt, wobei man den Becher (1) vorzugsweise im Bereich des Bodens (1.1) und/oder unteren Wandbereichs beheizt. Dabei kann man die Reaktorhülle (3) kühlen, um unerwünschte Anbackungen an der Reaktorwand zu vermeiden.

Das erfindungsgemäße Verfahren kann unter vermindertem Druck, unter erhöhtem Druck oder bei Normaldruck und bei einer Temperatur von ≥ 400 bis 1 200 °C durchgeführt werden. Geeigneterweise heizt man den Becher (1) oder Teile davon auf eine Temperatur von 400 bis 1 200 °C, vorzugsweise 600 bis 1 000 °C, auf.

Die Aufgabe der Substanz (A) bzw. eines entsprechenden Gasgemisches erfolgt bei vorliegendem Verfahren in geeigneter Weise über die Einheiten (3.2.), (3.1) und (2) und kann durch die Einheit (3.8) unterstützt werden.

Dabei ragt vorzugsweise der Substanzauslass (2.1) in das Freivolumen des Bechers (1) zwischen Boden (1.1) und Öffnungsbereich (1.2) hinein, wobei man die Orientierung von Substanzauslass (2.1) zum Boden (1.1) des Bechers (1) geeigneterweise über einen Temperaturdetektor (2.2) regelt und nachführt.

Ferner regelt man den Druck im Reaktor und die Zuführung der Substanz (A) vorzugsweise über die Ableitung der gasförmigen Produkte (C) mittels Gasfördereinheit (3.7) und/oder über die Dosiereinheit (3.2).

### Im Allgemeinen kann man das erfindungsgemäße Verfahren wie folgt ausführen:

In der Regel wird der Becherreaktor zunächst getrocknet, beispielsweise durch Ausheizen, anschließend evakuiert und mit einem O₂- sowie H₂O-freien Gas, das eine geringere Dichte besitzt als die zu zersetzende Substanz (A), gefüllt. Nun kann der Becher (1) auf Betriebstemperatur gebracht werden. Anschließend lässt man die Substanz (A) oder ein entsprechend verdünntes Gasgemisch über die Einheiten (3.2), (3.1) und (2) in das Innere des Bechers (1) ein. Der Fortlauf der Abscheidung von Feststoff (B) kann beispielsweise über die Temperaturänderung an der Einheit (2.2) festgestellt und der Einheit (2) nachgeregelt werden. Ferner kann die Aufgabemenge an (A) über die Einheiten (3.2) und/oder (3.8) geregelt werden.
So kann man nach dem erfindungsgemäßen Verfahren in einer dafür entwickelten neuen Vorrichtung hochreines Silicium vorteilhaft herstellen.

## Patentansprüche

1. Vorrichtung zur Abscheidung eines Feststoffs (B) durch thermische Zersetzung einer gasförmigen Substanz (A), wobei die eingesetzte Substanz (A) eine höhere Dichte besitzt als die bei der Zersetzung entstehenden gasförmigen Produkte (C),
**gekennzeichnet durch**
einen Becher (1), dessen Boden (1.1) in Richtung der Erdanziehung (g) und dessen Öffnungsbereich (1.2) entgegen der Erdanziehung (g) orientiert ist, der Becher (1) **durch** eine Heiz-, Temperaturmess- und Regeleinheit (3.3) direkt oder indirekt beheizbar ist,
eine Substanzaufgabeeinheit (2) mit Substanzzuleitung (3.1) und Dosierungseinheit (3.2), wobei die Substanzaufgabeeinheit (2) mit dem Substanzauslass (2.1) in Richtung der Erdanziehung (g) orientiert ist und in das Freivolumen des Bechers (1) zwischen Boden (1.1) und Öffnungsbereich (1.2) hineinragt,
eine Reaktorhülle (3) und einen Auslass (3.6) für gasförmige Produkte (C).

2. Vorrichtung nach Anspruch 1,
**dadurch gekennzeichnet,**
**dass** der Becher (1) und/oder die Substanzaufgabeeinheit (2) über mindestens eine Hebevorrichtung (3.4.1 bzw. 3.4.2) in Richtung der Erdanziehung abgesenkt bzw. angehoben werden können.

3. Vorrichtung nach Anspruch 1 oder 2,
**dadurch gekennzeichnet,**
**dass** dem Auslass (3.6) eine Verwirbelungssperre (3.5) vorgeschaltet ist.

4. Vorrichtung nach einem der Ansprüche 1 bis 3,
**dadurch gekennzeichnet,**
**dass** dem Auslass (3.6) eine Gasfördereinheit (3.7) nachgeschaltet ist.

5. Vorrichtung nach einem der Ansprüche 1 bis 4,
**dadurch gekennzeichnet,**
**dass** der Gasfördereinheit (3.7) eine Staubabscheidung (3.8) vor- und/oder nachgeschaltet ist.

6. Vorrichtung nach einem der Ansprüche 1 bis 5,
**dadurch gekennzeichnet,**
**dass** die Substanzaufgabeeinheit (2) im Bereich des Substanzauslasses (2.1) mit einem Temperaturdetektor (2.2) ausgestattet ist.

7. Vorrichtung nach einem der Ansprüche 1 bis 6,
**dadurch gekennzeichnet,**
**dass** die Substanzaufgabeeinheit (2) aus dem Feststoff (B), Quarzglas oder einem metallischen Werkstoff besteht.

8. Vorrichtung nach einem der Ansprüche 1 bis 7,
**dadurch gekennzeichnet,**
**dass** der Becher (1) aus dem Feststoff (B) besteht, eine Seitenhöhe von 10 bis 200 cm und eine Bodenfläche von 10 bis 10 000 cm² besitzt.

9. Vorrichtung nach einem der Ansprüche 1 bis 8,
**dadurch gekennzeichnet,**
**dass** die Einheit (1) und die Lanze der Einheit (2) aus hochreinem Silicium bestehen.

10. Vorrichtung nach einem der Ansprüche 1 bis 9,
**dadurch gekennzeichnet,**
**dass** der Becher (1) aus einer Scheibe aus Silicium als Boden (1.1) und einem Rohr aus Silicium als Wand besteht, wobei das Rohr mit einer der beiden gegenüberliegenden Öffnungsflächen des Rohres im Wesentlichen senkrecht auf der ebenen Fläche der Siliciumscheibe steht und der Außendurchmesser des Rohres kleiner gleich dem Durchmesser der Siliciumscheibe ist.

11. Vorrichtung nach Anspruch 10,
**dadurch gekennzeichnet,**
**dass** die Siliciumscheibe eine Waferscheibe ist.

12. Vorrichtung nach mindestens einem der Ansprüche 1 bis 11,
**dadurch gekennzeichnet,**
**dass** der Becher (1) in Höhe des Öffnungsbereichs (1.2) mit einer Platte (1.3) bedeckt ist, die im Zentrum einen Durchlass für die Einheit (2) aufweist.

13. Vorrichtung nach einem der Ansprüche 1 bis 12,
**dadurch gekennzeichnet,**
**dass** die Vorrichtung mit mindestens einer gasdicht schließenden Klappe oder einem gasdicht schließenden Deckel als Bestandteil der Reaktorhülle (3) ausgestattet ist.

14. Vorrichtung nach einem der Ansprüche 1 bis 13,
**dadurch gekennzeichnet,**
**dass** die Reaktorhülle (3) mit einer Kühlung und gegebenenfalls einer Heizung ausgestattet ist.

15. Vorrichtung nach einem der Ansprüche 1 bis 14,
**dadurch gekennzeichnet,**
**dass** die Reaktorhülle (3) druck- und vakuumfest ausgeführt ist.

16. Vorrichtung nach einem der Ansprüche 1 bis 15,
**gekennzeichnet durch** eine gasdichte Ausführung.

17. Verfahren zur Abscheidung eines Feststoffs (B) durch die thermische Zersetzung einer gasförmigen Substanz (A), wobei die eingesetzte Substanz (A) eine höhere Dichte besitzt als die bei der Zersetzung entstehenden gasförmigen Produkte (C), in einer Vorrichtung nach einem der Ansprüche 1 bis 16, indem man
- den Boden und/oder die Seitenwandung des Bechers (1) erwärmt,
- die gasförmige Substanz (A) über die Substanzaufgabeeinheit (2) in das Innere von Becher (1) einbringt,
- den durch die thermische Zersetzung von (A) entstehenden Feststoff (B) im Wesentlichen an der Innenseite des Bechers (1) abscheidet und
- die Produkte (C) über die Gasphase aus dem System entfernt.

18. Verfahren nach Anspruch 17,
**dadurch gekennzeichnet,**
**dass** man die Vorrichtung vor der Aufgabe der gasförmigen Substanz (A) evakuiert und/oder mit einem Gas oder Gasgemisch gezielt füllt, das eine geringere Dichte besitzt als die gasförmige Substanz (A).

19. Verfahren nach Anspruch 17 oder 18,
**dadurch gekennzeichnet,**
**dass** man als Substanz (A) reines Monosilan (SiH₄) einsetzt.

20. Verfahren nach einem der Ansprüche 17 bis 19,
**dadurch gekennzeichnet,**
**dass** man als Substanz (A) reines Silan (SiH₄) im Gemisch mit Wasserstoff, Stickstoff, Ammoniakgas, Argon und/oder Helium einsetzt.

21. Verfahren nach einem der Ansprüche 17 bis 20,
**dadurch gekennzeichnet,**
**dass** man bei der Beheizung des Bechers (1) eine Temperatur einstellt, die höher ist als die Zersetzungstemperatur von Monosilan.

22. Verfahren nach einem der Ansprüche 17 bis 21,
**dadurch gekennzeichnet,**
**dass** man das Verfahren unter vermindertem Druck, unter erhöhtem Druck oder bei Normaldruck und einer Temperatur ≥ 400 bis 1 200 °C durchführt.

23. Verfahren nach einem der Ansprüche 17 bis 22,
**dadurch gekennzeichnet,**
**dass** man die Reaktorhülle (3) kühlt.

24. Verfahren nach einem der Ansprüche 17 bis 23,
**dadurch gekennzeichnet,**
**dass** der Substanzauslass (2.1) in das Freivolumen des Bechers (1) zwischen Boden (1.1) und Öffnungsbereich (1.2) hineinragt und man die Orientierung von Substanzauslass (2.1) zum Boden (1.1) des Bechers (1) über einen Temperaturdetektor (2.2) regelt und nachführt.

25. Verfahren nach einem der Ansprüche 17 bis 24,
**dadurch gekennzeichnet,**
**dass** man den Druck im Reaktor und die Zufuhr der Substanz (A) über die Ableitung der gasförmigen Produkte (C) mittels Gasfördereinheit (3.7) und/oder die Dosiereinheit (3.2) regelt.

26. Verfahren nach einem der Ansprüche 17 bis 25,
**dadurch gekennzeichnet,**
**dass** man durch die gezielte thermische Zersetzung der Substanz (A) im Inneren eines Bechers (1) einen im Wesentlichen homogenen blockförmigen Körper bestehend aus dem Feststoff (B) erzeugt.

## Claims

1. A device for depositing a solid (B) by thermal decomposition of a gaseous substance (A), the substance (A) used having a higher density than the gaseous products (C) formed during the decomposition,
**characterized by**
a cup (1), the base (1.1) of which is oriented in the direction of the force of gravity (g) and the opening region (1.2) of which is oriented in the opposite direction to the force of gravity (g), the cup (1) being able to be heated directly or indirectly by a heating, temperature-measuring and control unit (3.3),
a substance-adding unit (2) with substance feedline (3.1) and metering unit (3.2), the substance-adding unit (2) being oriented with the substance outlet (2.1) in the direction of the force of gravity (g) and projecting into the free volume of the cup (1) between the base (1.1) and opening region (1.2),
a reactor casing (3) and an outlet (3.6) for gaseous product (C).

2. A device according to Claim 1, **characterized in that** the cup (1) and/or the substance-adding unit (2) can be raised and lowered in the direction of the force of gravity by means of at least one lifting device (3.4.1 and 3.4.2, respectively).

3. A device according to either of claims 1 and 2, **characterized in that** a turbulence barrier (3.5) is connected upstream of the outlet (3.6).

4. A device according to any one of claims 1 to 3, **characterized in that** a gas-conveying unit (3.7) is connected downstream of the outlet (3.6).

5. A device according to any one of claims 1 to 4, **characterized in that** a dust separation means (3.8) is connected upstream and/or downstream of the gas-conveying unit (3.7).

6. A device according to any one of claims 1 to 5, **characterized in that** the substance-adding unit (2) is equipped with a temperature detector (2.2) in the region of the substance outlet (2.1).

7. A device according to any one of claims 1 to 6, **characterized in that** the substance-adding unit (2) is composed of the solid (B), quartz glass or a metallic material.

8. A device according to any one of claims 1 to 7, **characterized in that** the cup (1) is composed of the solid (B), has a side height of 10 to 200 cm and a base area of from 10 to 10,000 cm².

9. A device according to any one of claims 1 to 8, **characterized in that** the unit (1) and the lance of the unit (2) are composed of high-purity silicon.

10. A device according to any one of claims 1 to 9, **characterized in that** the cup (1) is composed of a disc of silicon as the base (1.1) and a tube of silicon as the wall, the tube standing substantially vertically, by means of one of the two opposite opening surfaces of the tube, on the planar surface of the silicon disc, and the external diameter of the tube being less than or equal to the diameter of the silicon disc.

11. A device according to claim 10, **characterized in that** the silicon disc is a wafer.

12. A device according to at least one of claims 1 to 11, **characterized in that** the cup (1), at the level of the opening region (1.2), is covered with a plate (1.3) which, in the centre, has a passage for the unit (2).

13. A device according to any one of claims 1 to 12, **characterized in that** the device is equipped with at least one flap which closes in a gastight manner or a cover which closes in a gastight manner as part of the reactor casing (3).

14. A device according to any one of claims 1 to 13, **characterized in that** the reactor casing (3) is equipped with a cooling means and, if appropriate, a heating means.

15. A device according to any one of claims 1 to 14, **characterized in that** the reactor casing (3) is of pressure-resistant and vacuum-resistant design.

16. A device according to any one of claims 1 to 15, **characterized by** a gastight design.

17. A process for depositing a solid (B) by means of the thermal decomposition of a gaseous substance (A), the substance (A) used having a higher density than the gaseous products (C) formed during the decomposition, in a device according to any one of claims 1 to 16, in which
- the base and/or the side wall of the cup (1) is/are heated,
- the gaseous substance (A) is introduced into the interior of cup (1) via the substance-adding unit (2),
- the solid (B) which forms as a result of the thermal decomposition (A) is deposited substantially on the inner side of the cup (1), and
- the products (C) are removed from the system via the gas phase.

18. A process according to claim 17, **characterized in that** the device is evacuated and/or deliberately filled with a gas or gas mixture, which has a lower density than the gaseous substance (A), before the gaseous substance (A) is added.

19. A process according to either of claims 17 and 18, **characterized in that** pure monosilane (SiH₄) is used as the substance (A).

20. A process according to any one of claims 17 to 19, **characterized in that** pure silane (SiH₄) mixed with hydrogen, nitrogen, gaseous ammonia, argon and/or helium is used as the substance (A).

21. A process according to any one of claims 17 to 20, **characterized in that** the heating of the cup (1) establishes a temperature which is higher than the decomposition temperature of monosilane.

22. A process according to any one of claims 17 to 21, **characterized in that** the process is carried out at reduced pressure, at elevated pressure or at standard pressure and at a temperature of ≥ 400 up to 1200°C.

23. A process according to any one of claims 17 to 22, **characterized in that** the reactor casing (3) is cooled.

24. A process according to any one of claims 17 to 23, **characterized in that** the substance outlet (2.1) projects into the free volume of the cup (1) between base (1.1) and opening region (1.2), and the orientation of substance outlet (2.1) with respect to the base (1.1) of the cup (1) is controlled and tracked by means of a temperature detector (2.2).

25. A process according to any one of claims 17 to 24, **characterized in that** the pressure in the reactor and the feed of the substance (A) are controlled by means of the discharge of the gaseous product (C) by means of gas-conveying unit (3.7) and/or by means of the metering unit (3.2).

26. A process according to any one of claims 17 to 25, **characterized in that** a substantially homogeneous body in ingot form consisting of the solid (B) is produced by targeted thermal decomposition of the substance (A) in the interior of a cup (1).

## Revendications

1. Dispositif pour déposer une matière solide (B) par décomposition thermique d'une substance gazeuse (A), la substance (A) utilisée présentant une densité supérieure aux produits gazeux (C) provenant de la décomposition,
**caractérisé par**
une cuve (1), dont le fond (1.1) est orienté dans la direction de l'attraction terrestre (g) et sa zone d'ouverture (1.2) à l'inverse de l'attraction terrestre (g), la cuve (1) pouvant être chauffée directement ou indirectement par une unité de chauffage, de mesure de température et de régulation (3.3),
une unité de distribution de substance (2) comportant une conduite d'acheminement (3.1) de la substance et une unité de dosage (3.2), l'unité de distribution de substance (2) étant orientée, avec sa sortie de substance (2.1), dans la direction de l'attraction terrestre (g) et dépassant dans le volume libre de la cuve (1) entre le fond (1.1) et la zone d'ouverture (1.2),
une enveloppe de réacteur (3) et une sortie (3.6) pour les produits gazeux (C).

2. Dispositif selon la revendication 1,
**caractérisé en ce que**
la cuve (1) et/ou l'unité de distribution de substance (2) peuvent être abaissées dans la direction de l'attraction terrestre ou relevées par l'intermédiaire d'au moins un dispositif de levage (3.4.1 ou 3.4.2).

3. Dispositif selon la revendication 1 ou 2,
**caractérisé en ce qu'**
un système de blocage de tourbillonnements (3.5) est raccordé en amont de la sortie (3.6).

4. Dispositif selon l'une des revendications 1 à 3,
**caractérisé en ce qu'**
une unité de transport de gaz (3.7) est raccordée en aval de la sortie (3.6).

5. Dispositif selon l'une des revendications 1 à 4,
**caractérisé en ce qu'**
un système d'accumulation de poussières (3.8) est raccordé en amont et/ou en aval de l'unité de transport de gaz (3.7).

6. Dispositif selon l'une des revendications 1 à 5,
**caractérisé en ce que**
l'unité de distribution de substance (2) est munie d'un détecteur de température (2.2) au niveau de la sortie de la substance (2.1).

7. Dispositif selon l'une des revendications 1 à 6,
**caractérisé en ce que**
l'unité de distribution de substance (2) est composée d'une matière solide (B), de verre de quartz ou d'un matériau métallique.

8. Dispositif selon l'une des revendications 1 à 7,
**caractérisé en ce que**
la cuve (1) est composée d'une matière solide (B) et présente une hauteur latérale de 10 à 200 cm et une surface de fond de 10 à 10 000 cm².

9. Dispositif selon l'une des revendications 1 à 8,
**caractérisé en ce que**
l'unité (1) et la lance de l'unité (2) sont composées de silicium extrêmement pur.

10. Dispositif selon l'une des revendications 1 à 9,
**caractérisé en ce que**
la cuve (1) est composée d'un disque en silicium servant de fond (1.1) et d'un tube en silicium servant de paroi, le tube avec l'une de ses deux surfaces d'ouverture opposées étant disposé essentiellement perpendiculairement sur la surface plane du disque en silicium et le diamètre extérieur du tube étant inférieur ou égal au diamètre du disque en silicium.

11. Dispositif selon la revendication 10,
**caractérisé en ce que** le disque en silicium est une galette.

12. Dispositif selon au moins l'une des revendications 1 à 11,
**caractérisé en ce que**
la cuve (1) est recouverte, à hauteur de la zone d'ouverture (1.2), d'une plaque (1.3) qui présente en son centre un passage pour l'unité (2).

13. Dispositif selon l'une des revendications 1 à 12,
**caractérisé en ce que**
le dispositif est muni d'au moins un clapet refermable et étanche aux gaz ou d'un couvercle refermable étanche aux gaz qui se présente sous la forme d'un composant de l'enveloppe (3) du réacteur.

14. Dispositif selon l'une des revendications 1 à 13,
**caractérisé en ce que**
l'enveloppe (3) du réacteur est munie d'un système de refroidissement et éventuellement de chauffage.

15. Dispositif selon l'une des revendications 1 à 14,
**caractérisé en ce que** l'enveloppe (3) du réacteur est résistante à la pression et au vide.

16. Dispositif selon l'une des revendications 1 à 15,
**caractérisé par**
une construction étanche aux gaz.

17. Procédé pour déposer une matière solide (B) par décomposition thermique d'une substance gazeuse (A), la substance (A) utilisée présentant une densité supérieure aux produits gazeux (C) provenant de la décomposition, dans un dispositif selon l'une des revendications 1 à 16, dans lequel :
- on chauffe le fond et/ ou la paroi latérale de la cuve (1),
- on introduit la substance gazeuse (A) à l'intérieur de la cuve (1) par l'intermédiaire de l'unité de distribution de substance (2),
- on dépose la matière solide (B) provenant de la décomposition thermique de (A) essentiellement du côté intérieur de la cuve (1), et
- on extrait du système les produits (C) via la phase gazeuse.

18. Procédé selon la revendication 17,
**caractérisé en ce qu'**
on fait le vide dans le dispositif avant la distribution de la substance gazeuse (A) et/ au on le remplit de manière ciblée avec un gaz ou un mélange gazeux ayant une densité inférieure à la substance gazeuse (A).

19. Procédé selon la revendication 17 ou 18,
**caractérisé en ce que**
pour la substance (A), on utilise un monosilane pur (SiH₄).

20. Procédé selon l'une des revendications 17 à 19,
**caractérisé en ce que**
pour la substance (A), on utilise un silane pur (SiH₄) dans un mélange d'hydrogène, d'azote, de gaz ammoniac, d'argon et/ ou d'hélium.

21. Procédé selon l'une des revendications 17 à 20, **caractérisé en ce que**
pour le chauffage de la cuve (1), on règle une température supérieure à la température de décomposition du monosilane.

22. Procédé selon l'une des revendications 17 à 21,
**caractérisé en ce qu'**
on met en oeuvre le procédé à une pression réduite, à une pression augmentée ou à une pression normale et à une température de ≥ 400 à 1 200°C.

23. Procédé selon l'une des revendications 17 à 22,
**caractérisé en ce qu'**
on refroidit l'enveloppe (3) du réacteur.

24. Procédé selon l'une des revendications 17 à 23,
**caractérisé en ce que**
la sortie de substance (2.1) dépasse dans le volume libre de la cuve (1) entre le fond (1.1) et la zone d'ouverture (1.2) et on règle et redirige l'orientation de la sortie de substance (2.1) par rapport au fond (1.1) de la cuve (1) via un détecteur de température (2.2).

25. Procédé selon l'une des revendications 17 à 24,
**caractérisé en ce qu'**
on règle la pression régnant dans le réacteur et l'acheminement de la substance (A) via la dérivation des produits gazeux (C) à l'aide de l'unité de transport de gaz (3.7) et/ou de l'unité de dosage (3.2).

26. Procédé selon l'une des revendications 17 à 25,
**caractérisé en ce qu'**
on produit un corps en forme de bloc, essentiellement homogène, composé d'une matière solide (B), par la décomposition thermique ciblée de la substance (A) à l'intérieur d'une cuve (1).
